# EUROPEAN PATENT SPECIFICATION

(11) **EP 0 395 609 B1**
(45) Date of publication and mention of the grant of the patent: **15.11.1995**
(21) Application number: 90850139.8
(22) Date of filing: 11.04.1990
(51) Int. Cl.: H05K 1/11

(54) **Surface connector for radio frequency signals**
Oberflächenverbinder für Radiofrequenzsignale
Connecteur de surface pour signaux de radio-fréquence

(30) Priority: 12.04.1989 FI 891744
(43) Date of publication of application: 31.10.1990
(73) Proprietor: NOKIA MOBILE PHONES LTD., 24101 Salo (FI)
(72) Inventor: Kukkonen, Osmo, SF-24240 Salo (FI); Väyrynen, Antero, SF-24240 Salo (FI)
(74) Representative: Frain, Timothy John

(56) References cited:
- DE-A- 1 909 786
- DE-B- 2 623 274
- DE-U- 8 801 970
- IBM TECHNICAL DISCLOSURE BULLETIN, vol. 21, No. 5, October 1977, page 1761

## Description

The invention relates to a surface connector arrangement for a printed circuit board.

Usually coaxial connectors are used to connect radio frequency signals, which are carried on a central contact of the connector. The signal contact is then coaxially surrounded by a cylindrical contact part providing the earthing and the contact for the sheath. A connection comprises two coaxial connectors, a male and a female connector exactly fitting into each other. A connector of this type can also be mounted on a printed board. The known connectors are reliable but expensive due to their construction. The connection of the signal circuits of two printed boards through these connectors further requires an accurate mechanical fitting and a somewhat resilient construction of the mounting, which increases the cost of the connector.

Another coaxial connector is known from IBM Technical Disclosure Bulletin, Vol. 21, No. 5, October 1977, page 1761, disclosing a connector for electrically connecting two coaxial cables. The coaxial cables are preferably supported by printed-circuit boards and three bellows structures or contacts are employed for each coaxial cable connection.

In connection with printed boards for low frequency signals planar connectors are used, in which the contacts in their simplest form consist of the conductors printed on the board. However, the impedance level and the construction of these known connectors do not meet the requirements for the transmission of radio frequency signals.

The object of the invention is to provide a connector to be mounted on a printed board that reliably can be used for the transmission of radio frequency signals, while it is substantially more straightforward than the prior art coaxial connectors.

According to the present invention there is provided a surface connector arrangement, comprising a printed circuit board having a planar surface, and planar ground and signal contacts extending on said planar surface, and enabling transmission of a radio frequency signal to other contacts on another printed circuit board, the ground contact having first and second conjoining legs, said first leg being disposed on one side of said signal contact and said second leg being disposed on the other side of said signal contact.

The contacts forming the connector preferably consist of conductors printed on the board so that the contacts for the earthing and the sheath are symmetrically situated on both sides of the signal contact, and so that the planar contacts lie in the same plane and form the surface connector. The contacts may be located on the top surface of the printed board, but in another embodiment they may also be located on the edge of the printed board, perpendicular to the top surface of the board.

The conductors of the surface connector arrangement are dimensioned and located at a mutual distance such that the impedance level of the connector is low, preferably in the range between 50 and 150 ohms.

An embodiment of the invention is described, by way of example, with reference to the accompanying drawing, in which:
Figure 1 is a diagrammatic perspective view of the printed board surface connector arrangement in accordance with an embodiment of the invention; and
Figure 2 shows an embodiment further developed from Figure 1, in which the contacts are situated on parts protruding from the edge of the printed board; and
Figure 3 shows an embodiment somewhat modified compared to Figure 2.

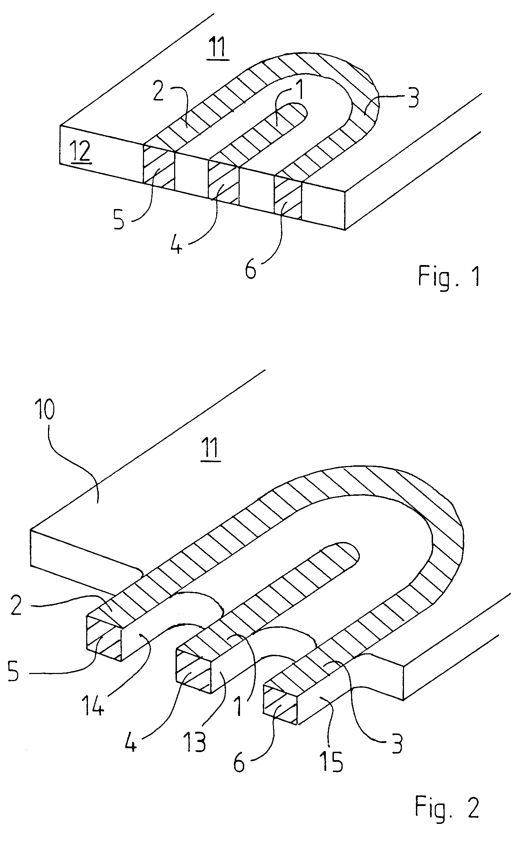

In Figure 1 a printed board 10 is provided with a surface connector arrangement with printed contacts 1-3 formed by printed conductors. The contact 1 is the signal contact. The contacts 2 and 3 are located electrically conducting symmetrically on both sides of the signal contact. As the conductors are thin, they may be considered to lie substantially in the plane of the printed board surface 11.

The extensions 4-6 of the conductors continue on the edge surface 12 of the printed board 10, thereby forming contact faces perpendicular to the plane 11.

The other connector of the connection, not shown in the figures, comprises pins fastened in a row, for example on a printed board. However, these contacts must be able to yield resiliently, so that the possibility of movement on one hand compensates for any inaccuracies and so that the spring force on the other hand ensures an adequate contact force between the connectors.

Such a connector which is described in the application Fl 891745 (EP-A-0 394 205) filed simultaneously with the present application, can be connected either in the direction of the surface 11 of Figure 1 perpendicularly against the contact faces 4-6, or perpendicularly against the contact points 1-3.

It is not necessary that the printed conductors are extended to the edge surface 12. Instead of printed circuits there may be used within the scope of the invention also for example separate metal strips, which electrically conducting are fastened to the printed board and the conductors.

The example shown in Figure 2 illustrates how the surface connector arrangement in accordance with an embodiment of the invention easily can be made protruding. The protrusions 13-15 are made when the board 10 is cut, whereby the contact surfaces 1-3 and 4-6 are made as printed contacts, as are the contacts on the printed board of Figure 1, simultaneously with the other conductor circuits.

The printed board of Figure 2 can be mounted in a housing, not shown, so that the connector and the contacts 1-6 protrude outside through an opening in the housing. In this way it is possible to protect the printed board against dust and/or radio frequency interference.

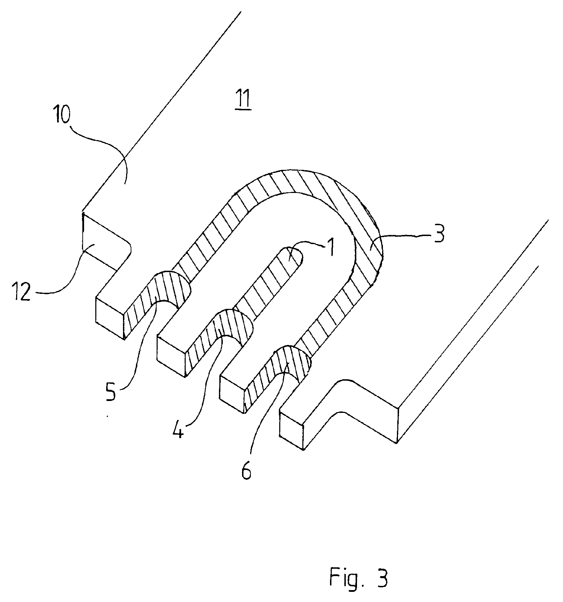

The embodiment of Figure 3 comprises protruding connecting elements analogous to Figure 2. However, the contact faces 4, 5 and 6 are here formed on the inner faces of notches, the contact surfaces 1, 3 in the plane 11 ending at the bottom of the notches and joining there the faces 4-6.

The surface connectors in Figures 1-3 constitute surface connectors meeting the requirements for radio frequency signals, primarily due to their symmetrical construction. The printed conductors 1-6 may thus be dimensioned (width, thickness, and distances between the conductors) according to methods well known in the art, so that the specific impedance or impedance level of the connector will be for example 50 ohms, which is the generally used impedance level on radio frequencies. The symmetrical construction will also reduce (or prevent) stray coupling.

The inventive surface connector arrangement described above may in principle also be realized so that the conductors 1-6 are duplicated, or so that there are a plurality of them, depending on the requirements of the circuit design and/or of the mechanical conditions.

In view of the foregoing it will be clear to a person skilled in the art that modifications may be incorporated without departing from the scope of the claims.

## Claims

1. A surface connector arrangement, comprising a printed circuit board (10) having a planar surface (11, 12), and planar ground and signal contacts (1-3) extending on said planar surface (11, 12), and enabling transmission of a radio frequency signal to other contacts on another printed circuit board, the ground contact (2, 3) having first and second conjoining legs (2, 3), said first leg (2) being disposed on one side of said signal contact (1) and said second leg (3) being disposed on the other side of said signal contact (1).

2. The arrangement of claim 1, characterized in that the first leg and second leg are disposed symmetrically with respect to the signal contact means.

3. The arrangement as claimed in claim 1 or 2, characterized in that the contact means (4-6) are situated substantially in the plane of that edge (12) of the printed board (10), where the signal is connected, the face (12) of the edge being substantially perpendicular to the planar surface (11) of the printed board.

4. The arrangement as claimed in claim 3, characterized in that the contact means (1-6) are printed contacts formed by conductors printed on the printed board (10).

5. The arrangement of claim 4, characterized in that the printed contacts (1-6) and the parts (13-15) of the printed board (10) forming their base protrude like fingers from the edge of the printed board, which otherwise is generally straight.

## Patentansprüche

1. Oberflächenverbinderaufbau, der eine gedruckte Leiterplatte (10) mit einer planaren Oberfläche (11, 12) sowie sich auf der planaren Oberfläche (11, 12) erstreckende planare Erd- und Signalkontakte (1 - 3) aufweist, und der eine Übertragung eines Radiofrequenzsignals zu anderen Kontakten auf einer anderen gedruckten Leiterplatte ermöglicht, wobei der Erdkontakt (2, 3) miteinander verbundene erste und zweite Schenkel (2, 3) hat. der erste Schenkel (2) an einer Seite des Signalkontakts (1) und der zweite Schenkel (3) an der anderen Seite des Signalkontakts (1) angeordnet ist.

2. Aufbau nach Anspruch 1, **dadurch gekennzeichnet**, daß der erste Schenkel und der zweite Schenkel symmetrisch zu den Signalkontaktmitteln angeordnet sind.

3. Aufbau nach Anspruch 1 oder 2, **dadurch gekennzeichnet,** daß die Kontaktmittel (4 - 6) im wesentlichen in der Ebene einer Kante (12) der gedruckten Leiterplatte (10) dort vorhanden sind, wo die Signalverbindung erfolgt, wobei die Kantenfläche (12) im wesentlichen senkrecht zur planaren Oberfläche (11) der gedruckten Leiterplatte liegt.

4. Aufbau nach Anspruch 3, **dadurch gekennzeichnet**, daß die Kontaktmittel (1-6) gedruckte Kontakte sind, gebildet durch auf die Leiterplatte (10) aufgedruckte Leiter.

5. Aufbau nach Anspruch 4, **dadurch gekennzeichnet,** daß die gedruckten Kontakte (1 - 6) und die ihre Basis bildenden Teile (13 - 15) der gedruckten Leiterplatte (10) von der Kante der gedruckten Leiterplatte fingerartig abstehen, die ansonsten im allgemeinen gerade ist.

## Revendications

1. Agencement de connecteur en surface, comprenant une carte de circuit imprimé (10), présentant une surface plane (11, 12), et des contacts de masse et de signal plans (1 à 3) s'étendant sur ladite surface plane (11, 12), et permettant la transmission d'un signal en radiofréquence vers d'autres contacts sur une autre carte de circuit imprimé, le contact de masse (2, 3) comportant des première et seconde pattes se rejoignant (2, 3), ladite première patte (2) étant disposée d'un côté dudit contact de signal (1) et ladite seconde patte (3) étant disposée de l'autre côté dudit contact de signal (1).

2. Agencement selon la revendication 1, caractérisé en ce que la première patte et la seconde patte sont disposées symétriquement par rapport au moyen de contact de signal.

3. Agencement selon la revendication 1 ou la revendication 2, caractérisé en ce que les moyens de contact (4 à 6) sont situés pratiquement dans le plan de ce bord (12) de la carte imprimée (10), où le signal est relié, la face (12) du bord étant pratiquement perpendiculaire à la surface plane (11) de la carte imprimée.

4. Agencement selon la revendication 3, caractérisé en ce que les moyens de contact (1 à 6) sont des contacts imprimés formés par des conducteurs imprimés sur la carte imprimée (10).

5. Agencement selon la revendication 4, caractérisé en ce que les contacts imprimés (1 à 6) et les parties (13 à 15) de la carte imprimée (10) formant leur base, débordent comme des doigts à partir du bord de la carte imprimée, qui par ailleurs est généralement rectiligne.
